# EUROPEAN PATENT APPLICATION

(11) **EP 1 884 305 A1**
(43) Date of publication of application: **06.02.2008**
(21) Application number: 06016372.2
(22) Date of filing: 04.08.2006
(51) Int. Cl.: B23K 1/20, B23K 1/00, B23K 3/08, H05K 3/34, B05B 12/02, B05B 1/30, B23K 101/42

(54) **Soldering flux application apparatus with an airbrush device ; Method of applying soldering flux to a surface of an object using an airbrush device**

(71) Applicant: Harman Becker Automotive Systems GmbH, 76307 Karlsbad (DE)
(72) Inventor: Metzger, Reinhold, 76863 Herxheim (DE); Kehm, Marc-Philipp, 76187 Karlsruhe (DE)
(74) Representative: Grünecker, Kinkeldey, Stockmair & Schwanhäusser Anwaltssozietät

(57) **Abstract**

The present invention relates to an apparatus for soldering comprising an airbrush device configured to apply soldering flux (2) by pressurized air (3) to a surface of an object to be soldered. The invention also relates to a method for applying soldering flux to a surface of an object that is to be soldered, comprising supplying the soldering flux (2) to an airbrush nozzle (1), supplying pressurized air (3) to the airbrush nozzle (1) and expelling the soldering flux (2) from the airbrush nozzle (1) by means of the supplied pressurized air (3).

## Description

### Field of Invention

The present invention relates to soldering facilitated by soldering flux. The invention, in particular, relates to the application of soldering flux to facilitate selective soldering of through-hole electronic components onto a printed circuit board.

### Background of the Invention

Soldering is almost exclusively performed with the components to be soldered exposed to air. Therefore, oxidation deteriorating the quality of soldering joints represents a severe problem in soldering techniques. In order to remove oxidation from the members being joined (solder tabs, terminals, lead wires) and to prevent further oxidation during soldering by sealing out air soldering flux is applied. Soldering flux additionally facilitates amalgamation leading to improved wetting characteristics of the liquid solder. Since flux is corrosive, the components have often to be cleaned with a damp sponge or other absorbent material after soldering to prevent damage.

Flux can be classified by type (e.g. Rosin (RO), Resin (RE), Organic (OR), Inorganic (IN)), activity (strength of fluxing) and reliability of residues from a surface insulation resistance (SIR) and electromigration standpoint, and whether or not it contains halide activators. For making lead wire splices, or soldering directly to constantan foil or copper terminals, the flux contained in a rosin-core solder is usually sufficient. With higher temperature solders, however, it is necessary to supply additional soldering flux as, e.g., a liquid activated-rosin flux such as M-Flux AR or a liquid acid flux such as M-Flux SS.

Accurate control of the application of flux is particularly important in selective soldering during which only through-hole electronic components onto a printed circuit board that has surface mount components on one side are solder bonded. This is usually done because the surface mount is not glued into place. Instead solder paste is used, and the solder joints are usually formed using a reflow oven.

Present-day flux systems apply the solder by means of "ink jet" technology. A cam follower is operated by a solenoid that controls the time periods of opening and closing the jet. The soldering flux is ejected through a small outlet (e.g., 0.1 mm) in form of droplets by a predetermined pressure. The size of the droplets and the amount of the ejected soldering flux are controlled by the time and frequency of opening of the outlet, respectively.

However, presently available flux systems cannot guarantee accurate flux application. One reason for this lies in the fact that salts that are dissolved in the flux readily crystallize even for a slightest evaporation of the solvent included in the flux. The crystallized salts deposit at the outlet of the jet system which results in some uncontrolled flux application. Short service intervals for the maintenance of the "ink jet" system are, thus, inevitable. Moreover, the ejected droplets of soldering flux may hit pins and through contact elements with a relatively high impact velocity which can lead to contamination by recoiled parts of the soldering flux droplets.

In addition to the problem of accurate flux application migration of surplus flux, in particular, to the location of surface mount components of printed circuit boards in the context of selective soldering may cause defective electronic components. Minimization of the amount of the applied soldering flux is, thus, considered advantageous but cannot be assured by the "ink jet" method.

Therefore, there is a need for an improved approach for the application of soldering flux to the surface of an object to be soldered.

### Description of the Invention

The above-mentioned problems are solved by an apparatus for soldering according to claim 1 comprising an airbrush device configured to apply soldering flux by pressurized air to a surface of an object to be soldered. The apparatus can, in particular, be an apparatus for selective soldering of through-hole electronic components onto a printed circuit board. The term "airbrush device" as used herein, in general, refers to a device in which the soldering flux is expelled from an airbrush nozzle by pressurized air.

The airbrush device may comprise a high-precision spray gun that works by passing a stream of compressed air through a pressure reduction means as, e.g., a venturi tube or an orifice plate, which creates a local reduction in air pressure (suction) that allows the soldering flux to be pulled up from an interconnected reservoir at normal atmospheric pressure. However, it may be preferred to have a pressure reducing means separate from the housing of the nozzle of the airbrush through which the soldering flux is expelled and to provide supply of the soldering flux, e.g., by a pump.

The high velocity of the air expelling the soldering flux atomizes the soldering flux into tiny droplets as it blows past a very fine metering component. The amount of soldering flux paint is controlled by a variable trigger which opens a very fine tapered needle that is the control element of the paint metering component. An extremely fine degree of atomization can be achieved, if need be.

Different from the art pressurized air is used to apply soldering flux by means of the airbrush device before the application of solder. Contrary, in a conventional device for the application of soldering flux a cam follower expels the flux by mechanical forces. It might also be mentioned that no piezo crystal is necessary as in the impulse jet technology wherein a medium to be applied to the surface of an object is supplied to the jet(s) with low air pressure and the droplets are formed by reduction of the volume of the jets caused by applied an voltage.

According to the invention, a high-precision application of soldering flux is enabled and, thus, high-precision soldering. Experimental studies employing the airbrush device have shown that the quality of soldered joints is satisfying and no substantial electromigration of the applied soldering flux has been observed. The invention enables soldering without or with only negligible flux residues.

According to an embodiment of the present invention, the airbrush device comprises a solenoid, in particular, an armature magnet, and a control unit configured to transmit control signals to the solenoid that is configured to adjust the amount of soldering flux output by the airbrush device in response to the control signals. An electromagnetic control of the amount of soldering flux applied to a surface of an object to be soldered represents an efficient and reliable way of controlling flux application.

As known from airbrush systems of the art, the airbrush device may comprise advantageously a needle and the solenoid can be configured to adjust the amount of soldering flux output by the airbrush device by controlling agitation of the needle. The needle may, furthermore, be agitated permanently in a vibrating manner in order to prevent plugging of the outlet of the airbrush device by soldering flux. The tapered needle opens and closes the flux outlet of the airbrush device.

According to an example of the inventive soldering apparatus, the airbrush device comprises an air supply means configured to provide a pressurized air stream by which the soldering flux is expelled from the airbrush device and a solenoid valve configured to control the pressurized air stream in response to control signals transmitted by the control unit corresponding to the ones transmitted to the solenoid.

The correspondence of the control signals may be that concurrently equivalent or the same control signals are transmitted to the solenoid and the solenoid valve in order to introduce pressurized air in an airbrush nozzle and to concurrently actuate a needle to open the outlet of the nozzle.

The airbrush device advantageously may further comprise one or more replacement orifice at the outlet side through which the soldering flux can be applied. These orifices are detachable and can be exchanged for applying flux with different widths according to the width(s) of the chosen orifice(s). Suitable orifices have widths of some hundred micrometers, for example. It may be preferred to employ orifices with diameters between 0.1 mm to 0.2 mm, e.g., of about 0.15 mm. Employment of replacement orifice facilitates a flexible application of soldering flux and soldering with soldered joints of different dimensions.

The present invention also provides use of an airbrush for applying soldering flux to a surface of an object that is to be soldered, in particular, use of an airbrush for applying soldering flux to at least one through-hole electronic component to be selectively soldered onto a printed circuit board in order to solve the above-mentioned problems.

Moreover, the above-mentioned problems are solved by a method for applying soldering flux to a surface of an object that is to be soldered according to claim 10, the method comprising the steps of
supplying the soldering flux to an airbrush nozzle;
supplying pressurized air to the airbrush nozzle; and
expelling the soldering flux from the airbrush nozzle by means of the supplied pressurized air.

According to an example of the inventive method, the supplied pressurized air, in particular, the flow rate, is controlled by a solenoid valve operated by a solenoid and the amount of the soldering flux that is expelled is adjusted by actuation of a needle provided for opening and closing the airbrush nozzle outlet. The needle is actuated by another solenoid.

The soldering flux can be expelled with a rate of between 0.1 ml per 90 seconds to some ml (say 5 ml) per 90 seconds, preferably, with a rate of between 0.5 ml per 90 seconds to 1.5 ml per 90 seconds. Satisfying results could be achieved with a flux rate of 1 ml per 90 seconds. In general, it should be noted that a sparing application of the soldering flux should be observed.

The atomizing pressure can advantageously be chosen at some bar, e.g. 4 bar, preferably at about 3 bar. The pressure control can be carried out by pressurized air of some bar, preferably of about 4 bar. The pressurized air should be free of water and oil and therefore, it is preferred that the pressurized air is filtered accordingly.

The present invention, furthermore, provides a method for selectively soldering of at least one through-hole electronic component onto a printed circuit board comprising the steps of applying a soldering flux to a part of the through-hole electronic component that is to be soldered by means of one of the above-mentioned examples of the method disclosed herein and subsequently applying a solder to the part of the through-hole electronic component on which the soldering flux is applied.

Additional features and advantages of the present invention will be described with reference to the single drawing.

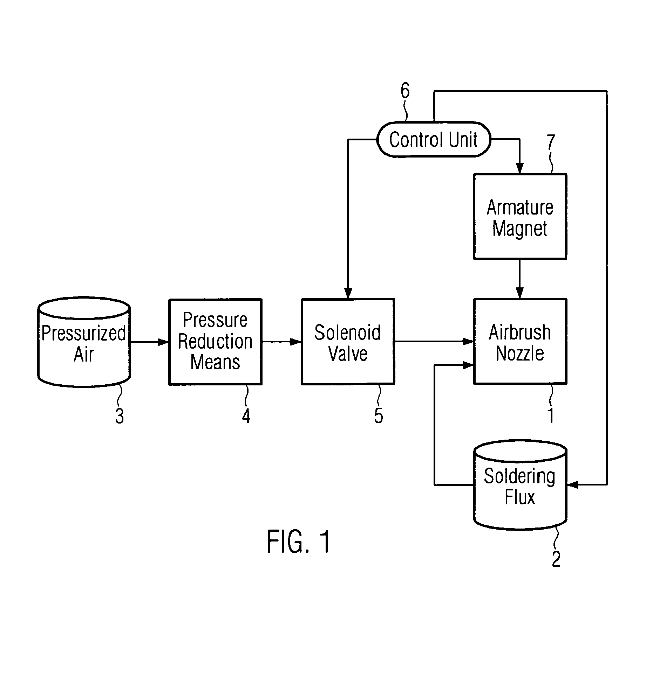

Figure 1 illustrates an example of the airbrush device being part of the inventive soldering apparatus.

According to Figure 1, a soldering apparatus (e.g. a soldering apparatus configured for selective soldering) comprises an airbrush device for the application of soldering flux. The soldering flux used for the soldering process is applied to a surface of a component to be soldered via an airbrush nozzle 1. The airbrush nozzle comprises a needle (not shown) for opening and closing the outlet of the nozzle.

The soldering flux is supplied by a flux container 2. Any soldering flux used in the present soldering technology might be used. In particular, a liquid activated-rosin flux such as M-Flux AR or a liquid acid flux such as M-Flux SS or some lead-free soldering, in general, can be applied by means of the airbrush nozzle 1.

Soldering flux with lead or lead-free soldering flux are both suitable. The soldering flux may have a water content from 0 % to 95 %.

Different from the art in the present invention the flux is expelled by pressurized air supplied by a pressurized air container 3. The air passes through a pressure reduction means 4 that may include a filtering means (not shown). According to this embodiment the pressure reduction means 4 and the airbrush nozzle are not formed in the same cabinet.

The air stream supplied from the pressurized air container 3 via the pressure reduction means 4 is provided to the airbrush nozzle in an actively controlled manner. The control of the air stream is achieved by a solenoid valve 5. In place of the pressurized air container 3 a compressor can might alternatively be used.

The needle provided in the airbrush nozzle 1 is actuated by an electromechanical solenoid, in this example, an armature (anchor) magnet 7, that not only causes opening and closing of the outlet but also some permanent movement of the needle in order to prevent sticking of soldering flux and jamming of outlet. The amplitude of the armature magnet 7 is limited for fine adjustment by an adjusting screw.

The soldering apparatus further comprises a control unit 6 configured to control the operation of the airbrush device. In particular, the control unit controls supply of the soldering flux (e.g. by a pump) from the soldering flux container 2. What is more, the control unit controls the operation of the armature magnet 7 and the solenoid valve 5 by corresponding control signals.

Thus, the pressurized air can be introduced in the airbrush nozzle 1 by the operated solenoid valve 5 and concurrently the needle of the airbrush nozzle 1 is moved for a matched operation of the solenoid valve 5 and the needle.

At the outlet of the airbrush nozzle 1 one or more detachable supplementary orifices may be provided. The widths of these orifices can be chosen to control the desired minimum and maximum width of the expelled soldering flux. Suitable widths for the orifices lie, e.g., in the range of some hundred micrometers.

In the description, reference is made to the accompanying figure that is meant to illustrate an embodiment of the invention. It is understood that such an embodiment does not represent the full scope of the invention.

## Claims

1. Apparatus for soldering, comprising
an airbrush device configured to apply soldering flux by pressurized air to a surface of an object to be soldered.

2. Apparatus according to claim 1, wherein the airbrush device comprises
a solenoid, in particular, an armature magnet;
and wherein the apparatus further comprises
a control unit configured to transmit control signals to the solenoid and wherein the solenoid is configured to adjust the amount of soldering flux output by the airbrush device in response to the control signals.

3. Apparatus according to claim 2, wherein the airbrush device comprises a needle and wherein the solenoid is configured to adjust the amount of soldering flux output by the airbrush device by controlling agitation of the needle.

4. Apparatus according to claim 2 or 3, wherein the airbrush device comprises
an air supply means configured to provide a pressurized air stream by which the soldering flux is expelled from the airbrush device; and
a solenoid valve configured to control the pressurized air stream in response to control signals transmitted by the control unit corresponding to the ones transmitted to the solenoid.

5. Apparatus according to one of the preceding claims, wherein the airbrush device further comprises a replacement orifice through which the soldering flux is applied.

6. Apparatus according to claim 5, wherein the replacement orifice has a diameter of between 0.05 mm to 0.25 mm, preferably of between 0.1 mm to 0.2 mm.

7. Apparatus according to one of the preceding claims, wherein the apparatus is configured to perform selective soldering.

8. Use of an airbrush for applying soldering flux to a surface of an object that is to be soldered.

9. Use of an airbrush according to claim 8 for applying soldering flux to at least one through-hole electronic component to be selectively soldered onto a printed circuit board.

10. Method for applying soldering flux to a surface of an object that is to be soldered, comprising
supplying the soldering flux to an airbrush nozzle;
supplying pressurized air to the airbrush nozzle; and
expelling the soldering flux from the airbrush nozzle by means of the supplied pressurized air.

11. Method according to claim 10, further comprising
controlling the supplied pressurized air by a solenoid valve operated by a solenoid and adjusting the amount of the soldering flux that is expelled from the airbrush nozzle by actuating a needle for opening and closing the airbrush nozzle by another solenoid.

12. Method according to claim 10 or 11, wherein the soldering flux is expelled with a rate of between 0.1 ml per 90 seconds to 5 ml per 90 seconds, preferably, with a rate of between 0.5 ml per 90 seconds to 1.5 ml per 90 seconds.

13. Method according to one of the claims 10 - 12, wherein the atomizing pressure of the soldering flux is between 1 bar and 5 bar, preferably between 2 bar and 4 bar.

14. Method according to one of the claims 10 - 13, wherein the pressurized air is supplied under a pressure of 1 bar to 7 bar, preferably under a pressure of 2 bar to 6 bar.

15. Method for selectively soldering of at least one through-hole electronic component onto a printed circuit board comprising the steps of applying a soldering flux to a part of the through-hole electronic component that is to be soldered by means of a method according to claim 9 or 14 and subsequently applying a solder to the part of the through-hole electronic component on which the soldering flux is supplied.
